# EUROPEAN PATENT SPECIFICATION

(11) **EP 2 334 147 B1**
(45) Date of publication and mention of the grant of the patent: **07.01.2015**
(21) Application number: 10192596.4
(22) Date of filing: 25.11.2010
(51) Int. Cl.: H05B 33/08, G02F 1/13357, H01L 33/50

(54) **Illumination device**
Beleuchtungsvorrichtung
Dispositif d'illumination

(30) Priority: 25.11.2009 JP 2009268110
(43) Date of publication of application: 15.06.2011
(73) Proprietor: Panasonic Corporation, Osaka 571-8501 (JP)
(72) Inventor: Tanaka, Kenichiro, Neyagawa Osaka (JP)
(74) Representative: Rüger, Barthelt & Abel

(56) References cited:
- WO-A1-2006/104319
- WO-A1-2007/114614
- WO-A1-2009/101718
- US-A1- 2002 158 565
- US-A1- 2009 180 273

## Description

### [Field of the Invention]

The present invention relates to an illumination device having a plurality of light-emitting devices each emitting a different color.

### [Background Art]

Recently, a light-emitting device employing a light-emitting element including a semiconductor light-emitting element such as an LED chip able to emit R (red), G (green), and B (blue) lights in a high output has been developed. In addition, a light-emitting device including: a light-emitting element including the semiconductor light-emitting element such as the LED chip; and a wavelength conversion part including a translucent material that covers the light-emitting element and that contains a fluorescent substance absorbing at least a part of light emitted from the light-emitting element and converting the wavelength to emit fluorescence that is a complementary color, and radiating, for example, a white light made by mixing the blue light from the light emitting element and a yellow light from a wavelength conversion part also has been developed. With the improvement of efficiency of a light output of each of the light emitting element, these light emitting devices are even used for an illumination device.

Meanwhile, in the illumination device employing these light emitting devices, for the purpose of setting a color tone of light radiated from the illumination device to a white light of a desired color temperature, there may be a case where plural types of light emitting devices of different emission colors are mounted on the same substrate and where the respective light emitting devices are lighted after adjusting their optical outputs.

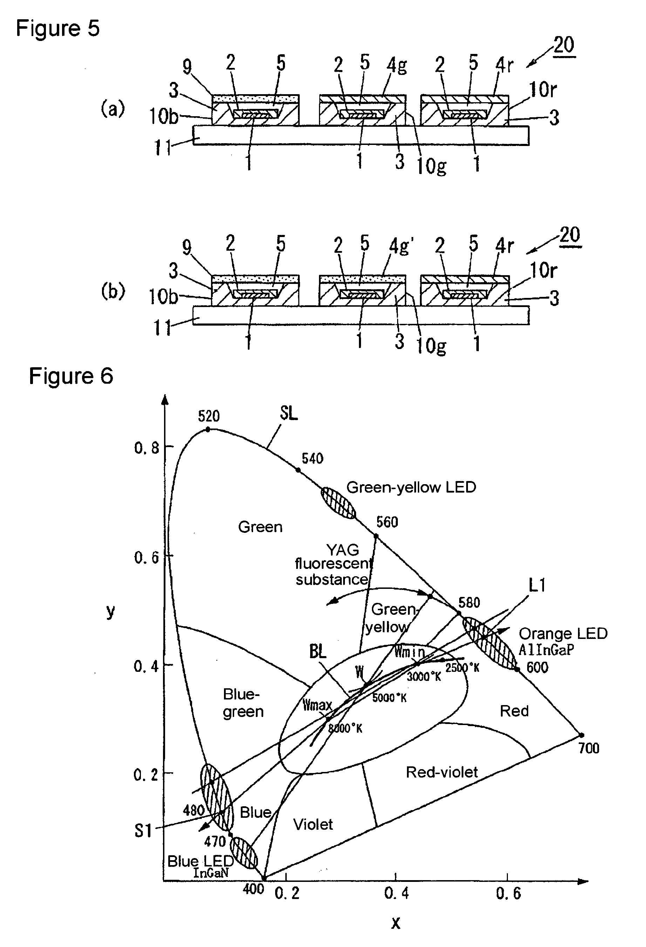

For example, as an illumination device having the plural types of light emitting devices of different emission colors, an illumination device including: a first light emitting device (an white LED emitting white light serving as a main light source) whose color temperature is set, in an xy chromaticity chart of the XYZ color system shown in Fig. 6, to a chromaticity (hereinafter referred to as a white point) W in a middle point between two chromaticity points Wmin and Wmax on a Planckian locus BL; a second light emitting device (a first auxiliary light source) emitting a peak wavelength in the vicinity of a point L1 intersecting with a spectrum locus SL in extending a section line connecting the white point W to the chromaticity point Wmin of low color temperature from the Wmin; and a third light emitting device (a second auxiliary light source) emitting a peak wavelength in the vicinity of a point S1 intersecting with a spectrum locus SL in extending a section line connecting the white point W to the chromaticity point Wmax of high color temperature from the Wmax, and being able to obtain mixed color light of a color temperature different from the color temperature of the first light emitting device serving as the main light source on the Planckian locus BL is known (for example, refer to patent literature 1).

The illumination device is configured to be able to correct not only the color temperature of light emitted from the illumination device but also the color rendering properties by using the auxiliary second and third light emitting devices having their peak wavelength in a specific wave length band to mix the light radiated from the second and the third light emitting devices with the light of the first light emitting device set to the white point W of a predetermined color temperature.

Meanwhile, in the illumination device of the above-mentioned patent literature 1, the first light emitting device is configured so as to emit the white light by combining a blue LED chip emitting a peak wavelength in a wavelength band from 450 to 460nm with a YAG fluorescent substance excited by the blue light radiated from the blue LED chip to radiate yellow fluorescence. In addition, the second light emitting device is configured by using an orange color LED chip of AlInGaP emitting a peak wavelength in 590nm. Moreover, the third light emitting device is configured by using a blue LED chip of InGaN emitting a peak wavelength in a wavelength band of 470 to 480nm. It is described that the above-mentioned illumination device is especially suitable for a shadowless light, a living room light, a make-up light, and the like.

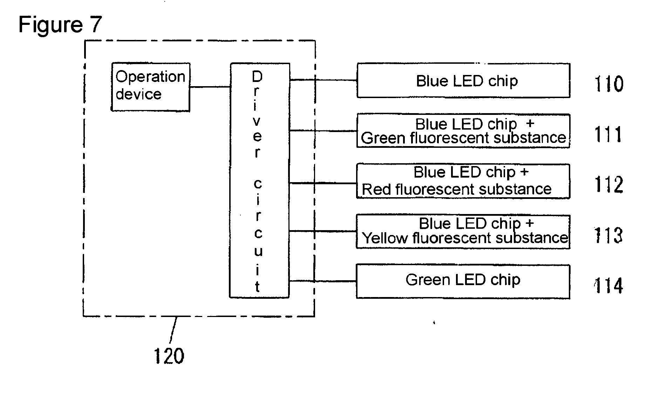

Additionally, an illumination device shown in Fig. 7 including: a light emitting device 110 using only a blue LED chip radiating blue light; a light emitting device 111 having a blue LED chip and a green fluorescent substance absorbing the blue light to radiate the green light; a light emitting device 112 having a blue LED chip and a red fluorescent substance absorbing the blue light to radiate the red light; a light emitting device 113 having a blue LED chip and a yellow fluorescent substance absorbing the blue light to radiate the yellow light; a light emitting device 114 using only a green LED chip; and a control device 120 for controlling light outputs of the respective light emitting devices 110 to 114 is also known (for example, refer to patent literature 2).

It is described that an illumination device of patent literature 2 is able to provide an illumination device having good color rending properties of light radiated from the illumination device and being able to change the brightness and color tone, by using a plurality of light emitting devices of different emission colors.

WO 2009/101718 A1 shows an illumination device having: a plurality of light emitting devices of different emission colors. A control device for controlling an optical output ratio in the plurality of the light emitting devices is provided for changing a color tone in mixed color light of light radiated from the plurality of the light emitting devices. Each of the plurality of the light emitting device includes a light emitting element and a first wavelength conversion part containing fluorescent material for absorbing at least a part of light radiated from the light emitting element and converting the wavelength to emit fluorescence, and a part of the light emitting devices among the plurality of the light emitting devices include a second wavelength conversion part for converting wavelengths of at least a part of the light radiated from at least one of the light emitting element and the first wavelength conversion part into an emission color different from the emission color of the light radiated from the light emitting element and the first wavelength conversion part. The layer of the second wavelength conversion part is directly attached to the layer of the first wavelength conversion part.

### [Conventional Technique Literature]

### [Patent Literature]

Patent literature 1= WO03/019072
Patent literature 2: JP2007-122950A

### [Disclosure of the Invention]

### [Problems to be solved by the Invention]

However, since the above-mentioned illumination device of patent document 1 uses the LED chips each including different use semiconductor material in the respective light emitting devices of different emission color, an initial emission characteristic and a temporal change characteristic of the LED chips are different from each other, and thus there is a problem that a color tone of the light radiated from the illumination device is varied to cause the color deviation due to a drive current, a temperature of the in-use light emitting device, a surrounding environment, the passage of time, and the like.

In addition, since the illumination device of patent literature 2 also uses the blue LED chip emitting a blue light and the green LED chip emitting a green light as the LED chips, the composition ratios of their semiconductor material are not the same, and thus there is a problem that a color tone of the light radiated from the illumination device is varied to cause the color deviation due to a drive current, a temperature of the in-use light emitting device, a surrounding environment, the passage of time, and the like, which are caused because an initial emission characteristic and a temporal change characteristic of the LED chips are different from each other. Meanwhile, when the light emitting devices 110, 111, 112 of the five light emitting devices 110 to 114 of patent document 2 are used, only the blue LED chip can be used as the LED chip of the light emitting device emitting a different color; however, a directional characteristic of the light emitting device 110 using only the blue LED chip is higher than those of the other light emitting devices 111 and 112, and accordingly there is a problem that a blue emission color stands out and a characteristic of color mixing is low.

Meanwhile, the illumination device is also able to maintain the emission of mixed color in a desired color tone by combining the respective light emitting devices of different emission colors, for example, R, G, and B and by constantly adjusting the optical outputs radiated from the respective light emitting devices. For example, it can be considered to try to obtain the light of stable color tone from the illumination device by controlling, in a feedback manner, the optical outputs of the respective light emitting devices in the illumination device after detecting a part of the light radiated from the illumination device with a light-receiving sensor.

However, in the illumination device, when a feedback control circuit part for controlling, in the feedback manner, the optical output of light radiated from the respective light emitting devices is provided with a control device, a structure of the control device becomes more complicate and expensive. In addition, in a case where the light-extraction efficiency is intended to be improved totally in the illumination device, the illumination device has a problem of system efficiency in the control device including the feedback circuit part.

Especially, in the illumination device, a high optical output is required more than ever; the larger the optical output of the LED chip used in the illumination device, the more the light radiated from the illumination device prominently causes the color deviation due to differences of the initial emission characteristic, the usage environment, and the temporal change characteristic, and accordingly the structure of the above-mentioned illumination device is not enough and a further improvement is required.

The present invention is achieved in consideration of the above-mentioned reasons, and the purpose is to provide, in a simple configuration more than ever, an illumination device able to suppress the color deviation due to the usage environment and temporal change and to stably obtain the mixed color in a desired color tone.

### [Means adapted to solve the Problems]

According to a first aspect of the present invention, an illumination device includes: a plurality of light emitting devices of different emission colors; and a control device for controlling an optical output ratio in the plurality of the light emitting devices, able to change a color tone in mixed color light of light radiated from the plurality of the light emitting devices of different emission colors, wherein each of the plurality of the light emitting device includes: a light emitting element; and a first wavelength conversion part for absorbing at least a part of light radiated from the light emitting element and converting the wavelength to emit fluorescence, and a part of the light emitting devices among the plurality of the light emitting devices include a second wavelength conversion part for converting wavelengths of at least a part of the light radiated from at least one of the light emitting element and the first wavelength conversion part into an emission color different from the emission color of the light radiated from the light emitting element and the first wavelength conversion part. The second wavelength conversion part is separated from the first wavelength conversion part via an air layer.

According to the invention, the plurality of light emitting devices commonly include: a light emitting element; a first wavelength conversion part for absorbing at least a part of light radiated from the light emitting element and converting the wavelength to emit fluorescence, and include: the light emitting elements for emitting light of substantially the same emission spectrum respectively by changing the emission color in the second wavelength conversion part; and the first wavelength conversion parts having substantially the same wavelength conversion characteristic, and accordingly a color deviation of light radiated from the illumination device can be suppressed, the color deviation depending on a drive current of the light emitting element, temperature in use, usage environment, and a temporal change characteristic.

Especially in the illumination device, a basic configuration is common in the light emitting device and an initial emission characteristic and a temporal change characteristic of the light emitting element can be substantially the same, and accordingly the color deviation based on the light emitting devices of different colors can be suppressed. For this reason, a feedback control circuit part for detecting the light radiated from the illumination device in an optical sensor and controlling the optical output radiated from the respective light emitting devices in a feedback manner to stably obtain the mixed color light of a desired color tone can be omitted. That is, the illumination device is able to stably obtain the mixed color light of desired color tone in a simpler configuration.

According to a second aspect of the present invention, in the first aspect of the present invention, the second wavelength conversion part includes a light diffusion material for diffusing light.

According to the invention, since the second wavelength conversion part provided to a part of the plurality of the light emitting devices includes the light diffusion material, a light distribution characteristic of light radiated from each of the plurality of the light emitting devices can be substantially uniformed by adjusting the light diffusion characteristic due to the light diffusion material, and accordingly a characteristic of color mixing of the light radiated from the illumination device can be improved more.

According to a third aspect of the present invention, in the first or second aspect of the present invention, the light emitting device not having the second wavelength conversion part of the plurality of the light emitting devices includes a diffusion layer for diffusing light from the first wavelength conversion part.

According to the invention, since the light emitting device not having the second wavelength conversion part of the plurality of the light emitting devices includes the diffusion layer for diffusing light from the first wavelength conversion part, a light distribution characteristic of light radiated from each of the plurality of the light emitting devices of different emission colors can be substantially uniformed by adjusting the light diffusion characteristic of the diffusion layer, and accordingly the characteristic of color mixing of the light radiated from the illumination device can be improved more.

According to a fourth aspect of the present invention, in one of the first to third aspects of the present invention, plural types of the second wavelength conversion parts are used in each the light emitting device, the respective second wavelength conversion parts include two or more types of common fluorescent substances, and content ratios of two or more types of the fluorescent substances are different.

According to the invention, plural types of the second wavelength conversion parts are used in each the light emitting device, the respective second wavelength conversion parts include two or more types of common fluorescent substances, and content ratios of two or more types of the fluorescent substances are different, and thereby plural types of the second wavelength conversion parts each having different wavelength conversion characteristic are formed. Accordingly, the light emitting device of the illumination device are able to easily design the color temperatures of light of different emission colors radiated from the light emitting devices only by adjusting the content ratios of the respective fluorescent substances in the plural types of the second wavelength conversion parts.

### [Effect of the Invention]

In the first aspect of the present invention, each of the plurality of the light emitting devices includes: the light emitting element; and the first wavelength conversion part for absorbing at least a part of light radiated from the light emitting element and converting the wavelength to emit fluorescence, and a part of the light emitting devices among the plurality of the light emitting devices include the second wavelength conversion part for converting wavelengths of at least a part of the light radiated from at least one of the light emitting element and the first wavelength conversion part into an emission color different from the emission color of the light radiated from the light emitting element and the first wavelength conversion part, and thereby obtaining a remarkable effect that an illumination device able to suppress the color deviation depending on a usage environment and a temporal change and to stably obtain the mixed color of a desired color tone in a simpler configuration can be provided.

### [Brief Description of the Drawings]

[Fig. 1] Fig. 1 is an illumination device according to a first embodiment, and (a) is a schematic perspective view, (b) is a schematic cross section view, and (c) is a principle explanation view.
[Fig. 2] Fig. 2 is a schematic cross section view showing another illumination device according to the first embodiment.
[Fig. 3] Fig. 3 is an illumination device according to a second embodiment, and (a) is a schematic perspective view, (b) is a schematic cross section view, and (c) is a principle explanation view.
[Fig. 4] Fig. 4 is a schematic cross section view showing another illumination device according to the second embodiment. [Fig. 5] Fig. 5 is a schematic cross section view showing an illumination device according to a third embodiment.
[Fig. 6] Fig. 6 is an explanation view explaining a conventional illumination device.
[Fig. 7] Fig. 7 is a schematic configuration view showing another conventional illumination device.

### [Best Mode for Carrying Out the Invention]

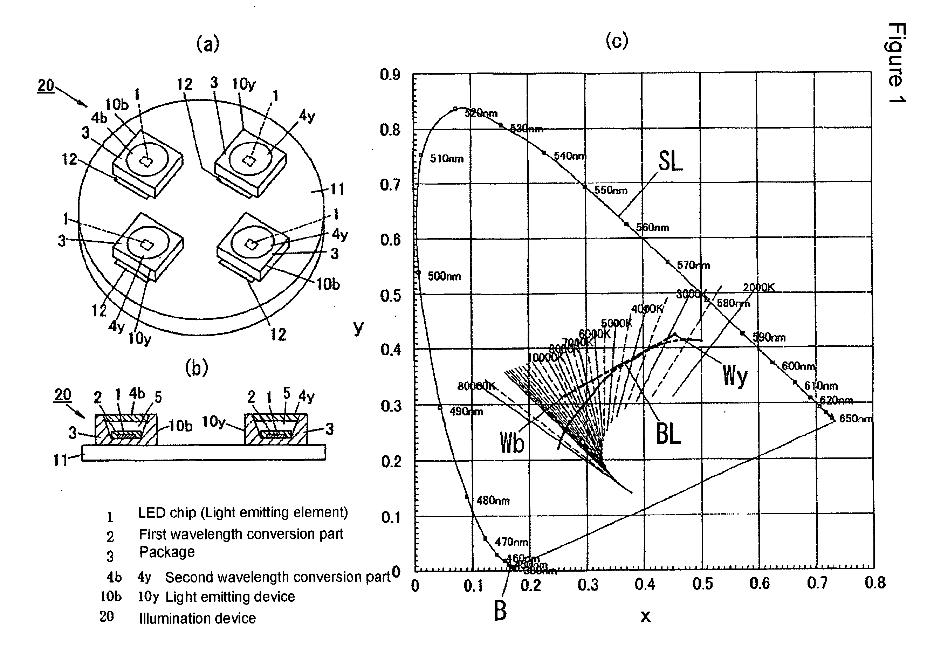

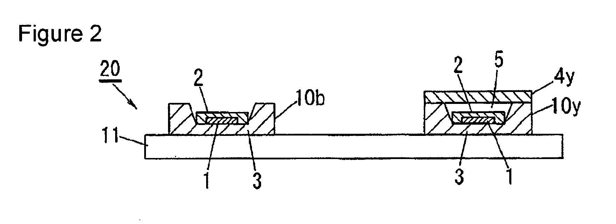

(First Embodiment)
An illumination device according to the present embodiment will be explained below on the basis of Figs. 1 and 2. In addition, the same numerals are added to the same members in Figs. 1 and 2, and thus the overlapping explanations will be omitted.

In order to radiate a mixed color in a desired color tone, an illumination device 20 shown in Fig. 1(a) and (b) according to the present embodiment includes plural types (two types in the present embodiment) of light emitting devices 10b and 10y emitting emission colors of different color temperature points Wb and Wy defined on a line segment along a Planckian locus BL shown in a xy color temperature chart in the XYZ color system of CIE (Commission International de l'Eclairage) shown in Fig. 1(c). Meanwhile, a series of isotemperature line shown by line segments each intersecting with the Planckian locus BL is also exemplified in the xy color temperature chart of Fig. 1(c).

In the illumination device 20 according to the present embodiment, the light emitting device 10b emits a bluish white light represented by the color temperature point Wb that is a high color temperature in the xy color temperature chart, and the light emitting device 10y emits yellowish white light represented by the color temperature point Wy that is a low color temperature in the xy color temperature chart.

The illumination device 20 is able to radiate a mixed color light (here the white light) in a color tone on a line segment of a dashed line connecting the color temperature point Wb of the light radiated from the light emitting device 10by to the color temperature point Wy of the light radiated from the light emitting device 10y, the color temperature points being in a relation of complimentary colors, by controlling an optical output ratio between the light emitting device 10b and the light emitting device 10y in a control device (not shown in the drawings).

More specifically, in the illumination device 20 shown in Fig. 1(a) according to the present embodiment, two light emitting devices 10b and 10b emitting the bluish white light and two light emitting devices 10y and 10y emitting the yellowish white light are mounted on one surface of the circuit substrate 11 having a wiring pattern serving as a power supply path to the respective light emitting devices 10b and 10y, respectively. For example, the circuit substrate 11 is a disk-shaped metal base substrate on which a wiring pattern plated by Au is formed. The respective external electrodes of the light emitting devices 10b and 10y is electrically connected to a land 12 of a pair of wiring patterns of the circuit substrate 11 by a conductive member (for example, AuSn and Ag paste), respectively. Meanwhile, the circuit substrate 11 of the illumination device 20 according to the present embodiment is formed in a disk shape; however, the substrate may be formed not only in the disk shape but also in an elliptical plate shape and in a polygonal plate shape such as a rectangular plate shape.

For example, the respective light emitting devices 10b and 10y of the illumination device 20 use a package 3 including alumina ceramic material that has a common outer shape and that forms a concave portion concaved inside and a pair of conductor patterns (not shown in the drawing) on the internal bottom surface of the concave portion. On the internal bottom surfaces of the concave portions in the packages 3 of the light emitting devices 10b and 10y, a LED chip 1 is mounted.

In the LED chip 1, an n-type gallium nitride compound semiconductor layer, a light emitting layer including a gallium nitride compound semiconductor including In, and a p-type gallium nitride compound semiconductor layer are laminated on a sapphire substrate in turn. Additionally, in the LED chip 1, a part of the light emitting layer and a part of the p-type gallium nitride compound semiconductor layer are removed to partially expose the n-type gallium nitride compound semiconductor, and an anode electrode and a cathode electrode electrically connected to the respective p-type and n-type gallium nitride compound semiconductor layer are provided on the same plane side, respectively. The LED chip 1 mounts the anode electrode and the cathode electrode provided on the same plane side of the LED chip 1 on a pair of conductor patterns formed in the packages 3 of the light emitting devices 10b and 10y so that an electric power can be supplied by mounting a flip chip using an Au bump.

Each of the LED chips 1 of the light emitting devices 10b and 10y mounted on the circuit substrate 11 are common, and radiates blue light whose peak wavelength is, for example, within a range from 450nm to 470nm (for example, the color temperature point B in the xy color temperature chart of Fig. 1(c)) due to emission caused by the power supply, respectively. In addition, to the LED chip 1 mounted on the internal bottom surface of the concave portion in the package 3 of each of the light emitting devices 10b and 10y, a first wavelength conversion part 2 is provided so as to cover the LED chip 1. Each of the first wavelength conversion parts 2 is common, and a yellow fluorescent substance able to absorb the blue light from the LED chip 1 to emit the yellow fluorescence (for example, (Sr, Ba)₂SiO₄ doped by Eu and Y₃A1₅O₁₂ doped by Ce) is homogeneously dispersed in a silicone resin serving as a binder, is applied on the LED chip 1, and is made cure.

Second wavelength conversion parts 4b and 4y are formed in a film shape by homogeneously dispersing a yellow fluorescent substance able to absorb the light from the LED chip 1 to emit the yellow fluorescence (for example, (Sr, Ba)₂SiO₄ doped by Eu and Y₃A1₅O₁₂ doped by Ce) in a silicone resin serving as a binder. Meanwhile, the types of the fluorescent substances in the second wavelength conversion parts 4b and 4y are common, and the content ratio in the binder is different.

By fitting and fixing the second wavelength conversion parts 4b and 4y in the concave portions on the respective light emitting devices 10b and 10y, a ratio to be converted in wavelength by the second wavelength conversion parts 4b and 4y varies in a part of the blue light radiated from the LED chip 1 and transmitting through the first wavelength conversion part 2, and accordingly the light emitting device 10b can emit the bluish white light and the light emitting device 10y can emit the yellowish white light.

The illumination device 20 is able to control and radiate a mixed color light of desired color tone from the illumination device 20 by controlling optical output ratios of the respective light emitting devices 10b and 10y with the control device (not shown in the drawing).

Meanwhile, in order to adjust the color temperature of light radiated from the illumination device 20, the illumination device 20 has the light emitting devices 10b and 10y of different emission colors. Accordingly, as the configuration of the light emitting device 10b emitting the blue light that is on a short wavelength side in the visible light, a configuration where the light emitting device 10b and the light emitting device 10y uses the common LED chip 1 and the first wavelength conversion part 2 in the internal bottom surface of the concave portion in the common package 3 and the light emitting device 10b does not use only the second wavelength conversion part 4b may be employed as in another illumination device 20 according to the present embodiment shown in Fig. 2.

For example, in the illumination device 20 shown in Fig. 2, each of the light emitting devices 10b and 10y may be configured by including: the LED chip 1 able to radiate violet-blue light in a peak wavelength of 420nm; the package 3 including ceramic material for making the LED chip 1 be mounted on the internal bottom surface of the concave portion; and the first wavelength conversion part 2 that covers the LED chip 1 mounted on the internal bottom surface of the concave portion in the package 3, that absorb the violet-blue light radiated by the LED chip 1 and converts the wavelength, and that is including translucent material (for example, glass and a silicon resin) including blue fluorescent substance able to emit the blue fluorescence (for example, La₃Si₈N₁₁O₄ doped by Ce and LaA1(Si₆-_{z}Al_{z})N₁₀-_{z}O_{z} doped by Ce), respectively.

Meanwhile, to make the light emitting device 10b radiate the bluish white light, it is preferable that the fluorescent substance has a broad emission spectrum; the yellow fluorescent substance able to emit the yellow fluorescence (for example, (Sr, Ba)₂SiO₄ doped by Eu and Y₃A1₅O₁₂ doped by Ce) may be contained in the first wavelength conversion part 2 in addition to the blue fluorescent substance able to emit the blue fluorescence.

Here, the light emitting device 10y basically has the same configuration as that of the light emitting device 10b, the second wavelength conversion part 4y is separately provided on a light emitting surface side via an air layer 5, and the second wavelength conversion part 4y includes the yellow fluorescent substance excited by at least one of the blue light radiated from the LED chip 1 and the first wavelength conversion part 2 each emitting the blue-violet light (for example, (Sr, Ba)₂SiO₄ doped by Eu and Y₃A1₅O₁₂ doped by Ce). Meanwhile, in the light emitting devices 10b and 10y according to the present embodiment, the package 3 is formed by using the ceramic material, but the material of the package 3 is not limited to the ceramic material.

In the illumination device 20 shown in Fig. 2 according to the present embodiment, the LED chips 1 having the same specification (the semiconductor material, emission wavelength, and structure of the light emitting layer are substantially the same) is used as the respective LED chips 1.

In the above-mentioned illumination device 20 according to the present embodiment, two types of the light emitting devices 10b and 10y emitting an emission color in each of color temperature points Wb and Wy is configured so that the color tone of the mixed light radiated from the illumination device 20 can be set to the color temperature point on a line segment connecting two color temperature points Wb and Wy defined on the Planckian locus BL in the xy color temperature chart shown in Fig. 1(c).

Accordingly, the illumination device 20 can be a highly reliable device that suppresses the color deviation of the light radiated from the light emitting devices 10b and 10y, the color deviation depending on the drive current, usage environment, and a temporal change characteristic of the violet-blue LED chip 1. Additionally, in a case of changing the color tone in the mixed color radiated from the illumination device 20, the illumination device 20 is able to stably obtain the mixed color of a desired color tone by only changing the ratio of optical output radiated from the light emitting devices 10b and 10y even in a simply configured control device which does not have the feedback control circuit part.

In addition, in the manufacture of the illumination device 20 according to the present embodiment, the plurality of light emitting devices 10b having the violet-blue LED chip 1 of the same specification, the first wavelength conversion part 2, and the package 3 are prepared in all light emitting devices 10b and 10y, and the devices are configured so that the second wavelength conversion part 4y can separately cover only a part of the light emitting device 10b to be the light emitting device emitting the yellowish white light. Accordingly, the manufacturing of the respective light emitting devices 10b and 10y can be easy, an yield of the manufacturing of the illumination device 20 can be improved to be high, and the illumination device 20 able to suppress the generation of color deviation can be easily manufactured.

In the mixed color radiated from the illumination device 20, the color tone can be controlled by controlling the drive current supplied to the LED chips 1 of the light emitting devices 10b and 10y with the control device and by controlling intensity of the optical output radiated from each of the light emitting devices 10. In the illumination device 20 according to the present embodiment, even in the control device which does not have the feedback control circuit part, the color deviation depending on the usage environment and the temporal change can be suppressed and the mixed color light of a desired color tone can be stably obtained.

Meanwhile, when trying to improve the optical output, the LED chip 1 that is a light emitting element tends to emit the light of a sharp and narrow wavelength in comparison the emission spectrum of the light radiated for the fluorescence with that of the LED chip 1. Meanwhile, the LED chip 1 sometimes not only lowers the optical output but also shifts the emission spectrum to the long wavelength side because of the heating caused by increase of the drive current.

For this reason, since not only the wavelength of light radiated from the LED chip 1 is changed but also a shift between the emission spectrum of light radiated from the LED chip 1 and the excitation spectrum of fluorescence absorbing the light from the LED chip 1 is generated, the change of optical output radiated from the fluorescent substance sometimes occurs because of the change of excitation efficiency of the fluorescence.

However, in the light emitting devices 10b and 10y in Fig 2 according to the present embodiment, the LED chip 1 and the first wavelength conversion part 2 having the fluorescent substance are combined as a basic configuration, and since the emission spectrum of the light radiated from the first wavelength conversion part 2 has a broader spectrum width in comparison with the emission spectrum of the LED chip 1, it is possible to suppress the variation of optical output in the second wavelength conversion part 4y and to suppress that the color tone of light radiated from the light emitting devices 10b and 10y varies.

Each component used in the illumination device 20 according to the present embodiment will be described in detail below.

The light-emitting element used in the illumination device 20 according to the first embodiment is able to emit light due to power supply. The light radiated by the light-emitting element can be the violet-blue light and the blue light each whose peak wavelengths are 405nm to 490nm; however, the light is not limited to only the violet-blue light and the blue light and accordingly other wavelengths such as ultraviolet light may be used. As the LED chip 1 serving as the light-emitting element, a chip where an n-type gallium nitride compound semiconductor layer, a gallium nitride compound layer including indium serving as a light-emitting layer having a multi quantum well structure or a single quantum well structure, and a p-type gallium nitride compound semiconductor layer are laminated in turn on a crystal growth substrate such as a sapphire substrate, a spinel substrate, a gallium nitride substrate, a zinc oxide substrate, and a silicon carbide substrate can be exemplified for example.

Meanwhile, in the LED chip 1 using an insulating substrate as the crystal growth substrate, the anode electrode and the cathode electrode can be formed on the same plane side respectively by exposing a part of the n-type gallium nitride compound semiconductor layer from the p-type gallium nitride semiconductor layer side. In addition, the LED chip 1 using a conductive substrate can form the anode electrode and the cathode electrode on both sides in a thickness direction of the LED chip 1.

If material showing a good ohmic characteristic with the gallium nitride compound semiconductor layer, for example, a laminated film including an Ni film and an Au film, an A1 film, and an ITO film is employed, the material of the anode electrode and the cathode electrode provided to the LED chip 1 is not limited.

The LED chip 1 in which the anode electrode and the cathode electrode are provided on the same plane side can mount the flip chip using a metal bump such as an Au bump on a pair of conductor patterns formed on the internal bottom surface of the concave portion in the packages 3 of the light emitting devices 10b and 10y. In addition, in the case where the LED chip 1 in which the anode electrode and the cathode electrode are formed on both sides in the thickness direction is used as the LED chip 1, one of a pair of the conductive patterns formed on the package 3 in which the LED chip 1 is mounted is electrically connected to the anode electrode or the cathode electrode of the LED chip 1 via the conductive member (for example, AuSn and Ag paste) by the die bonding. Moreover, the other one of the cathode electrode and the anode electrode on the light-extraction surface side of the LED chip 1 is electrically connected to the other one of the conductive pattern via a wire (for example, a gold line and an aluminum line).

Meanwhile, in the illumination device 20 according to the present embodiment, the single LED chip 1 is mounted on the light emitting devices 10b and 10y respectively; however, the number of the LED chip 1 is not limited to one and accordingly the plurality of LED chip 1 may be employed. In this case, each of the LED chip 1 is electrically connected arbitrarily in series, in parallel, and in series parallel by using a conductor pattern. In addition, the LED chips 1 of the same type may be used, and the plurality of LED chips 1 emitting different emission wavelengths may be used.

It is preferred in the illumination device 20 that the light radiated from the light emitting device 10b and the light radiated from the light emitting device 10y, the devices emitting different colors, are in a complementary color relationship. For example, the illumination device 20 uses the light emitting device 10b emitting the blue color and the light emitting device 10y emitting the yellow color. Thus, the light emitting devices 10b and 10y efficiently light the first wavelength conversion part 2 and the second wavelength conversion parts 4b and 4y by using, of the light emitting devices 10b and 10y emitting different colors, the LED chip 1 radiating the light on a shorter wavelength side (for example, the violet-blue) than the blue light that is the light of the shortest main emission wavelength radiated from the light emitting devices 10b and 10y respectively.

Next, the package 3 is required to be able to mount the LED chips 1 serving as the light-emitting elements, respectively, and the power supply path of the LED chip 1 can be configured by using the pair of conductor patterns on the internal bottom surface of the concave portion in the package 3 (for example, the conductor pattern whose uppermost surface is plated by Au). The above-described packages 3 of the light emitting devices 10b and 10y may be formed by using: a ceramic substrate using alumina, aluminum nitride, and the like; a metal base substrate using metal material such as Cu, Al, Fe, and the like; an epoxy resin substrate; and the like. In addition, the package 3 may form the pair of conductor pattern be by molding a resin, for example, an acrylic resin and an epoxy resin.

Meanwhile, in the light emitting devices 10b and 10y, the conductor pattern may be configured as external electrodes of the light emitting devices 10b and 10y by being extended from the internal bottom surface of the concave portion in the package 3 to the side surface and the reverse side of the package 3. The above-mentioned external electrodes of the light emitting devices 10b and 10y can be electrically connected to the circuit substrate 11 easily in a reflow process.

The circuit substrate 11 of the illumination device 20 according to the present embodiment is able to mount the plurality of light emitting devices 10b and 10y and to supply the electric power to the light emitting devices 10b and 10y. The circuit substrate 11 in the illumination device 20 according to the present embodiment is formed in the disk shape; however, a reflector for reflecting the light from the light emitting devices 10b and 10y may be provided to a circumferential portion on the above-mentioned one surface of the circuit substrate 11. Additionally, in order to mix the light from the light emitting devices 10b and 10y and to radiate the light in a desired direction, the illumination device 20 may include a light distribution control part (not shown in the drawing) such as a diffuser panel and a lens on the light emitting devices 10b and 10y, separately.

In addition, the illumination device 20 may include a reflection film (not shown in the drawing) on the circuit substrate 11; this reflection film is able to efficiently reflect the light radiated from the light emitting devices 10b and 10y, and specifically may be configured by using glass containing: metal material such a A1, A1 alloy, Ag, and Ag alloy; and inorganic material serving as a white pigment such as BaSO₄.

The first wavelength conversion part 2 used in the present embodiment absorbs at least a part of the light radiated by the LED chip 1 that is the light-emitting element to convert the wavelength, and emits the fluorescence of the main emission wavelength on a longer wavelength side than that of the light from the LED chip 1.

For example, the first wavelength conversion part 2 may be formed by including, in the translucent material such as the silicon resin, the acrylic resin, the epoxy resin, and the glass, the fluorescent substance absorbing a part of the light radiated from the LED chip 1 to radiate the fluorescence of the main emission wavelength on a longer wavelength side.

In addition, the second wavelength conversion parts 4b and 4y include the fluorescent substance that absorbs a part of the light radiated from the LED chip 1 or of the fluorescence radiated from the first wavelength conversion part 2 to radiate the fluorescence of the main emission wavelength on a longer wavelength side, and radiate the light of a longer wavelength than the main emission wavelength of the light radiated from the first wavelength conversion part 2. In the same manner as that of the first wavelength conversion part 2, the second wavelength conversion parts 4b and 4y are also able to contain, for example, the fluorescent substance into the translucent material such as the silicon resin, the acrylic resin, the epoxy resin, and the glass.

To make the mixed color light radiated by the illumination device 20 be the highly-rendered white light, in a combination of: the LED chips 1 radiating the blue light of the light emitting devices 10b and 10y; and the first wavelength conversion part 2 and the second wavelength conversion parts 4b and 4y, the yellow fluorescent substance can be used as the fluorescent substance for the first wavelength conversion part 2, and the green fluorescent substance and the red fluorescent substance can be used as the fluorescent substance for the second wavelength conversion parts 4b and 4y.

In the case where the light emitting devices 10b and 10y use a light emitting device able to emit light of different two colors or three colors, the illumination device 20, for the purpose of maximizing the chroma in varying the color, is desired to be configured to include the light emitting devices 10b and 10y emitting the light of color temperatures separated as far as possible within a range where the color is to be varied. On the contrary, the color deviation is largely caused within a range where the color is to be varied in the configuration of the light emitting devices 10b and 10y emitting the light of the color temperatures as far as possible, and the control accuracy to control the mixed color light to be in a desired color tone deteriorates, and accordingly it is important to consider both of: the obtained color tone of mixed color light; and the color deviation of emission light and arbitrarily set the tone and deviation.

As the fluorescent substance used for the first wavelength conversion part 2 and the second wavelength conversion parts 4b and 4y, a silicate fluorescent substance such as Ba₂SiO₄ doped by Eu and (Sr, Ba)₂Si0₄ doped by Eu, and a nitride fluorescent substance such as CaA1SiN₃ doped by Eu, Sr₂Si₅N₈ doped by Eu, Ca₂Si₅N₈ doped by Eu, SrSi₇N₁₀ doped by Eu, and CaSi₇N₁₀ doped by Eu in addition to an aluminate fluorescent substance such as Y₃A1₅O₁₂ doped by Ce and Tb₃A1₅O₁₂ doped by Ce.

For example, Ca₃SC₂Si₃O₁₂ doped by Ce, CaSc₂O₄ doped by Ce, (Sr, Ba, Ca)SiO₄ doped by Eu, and the like are exemplified as the green fluorescent substance emitting the green light, an aluminate fluorescent substance such as Y₃A1₅O₁₂ doped by Ce and Tb₃A1₅O₁₂ doped by Ce, (Sr, Ba)₂SiO₄ doped by Eu, and the like are exemplified as the yellow fluorescent substance emitting the yellow light, and a nitride fluorescent substance such as CaAlSiN₃ doped by Eu, (Sr, Ca, Mg)AlSiN₃ doped by Eu, (Sr, Ca, Mg)AlSiN₃ doped by Ce, and (Sr, Ca)₂Si₅N₈ doped by Ce is exemplified as the red fluorescent substance.

Meanwhile, nothing is provided to the package 3 storing the LED chip 1 and the first wavelength conversion part 2 in the light emitting device 10b of the illumination device 20 shown in Fig. 2 according to the present embodiment; however, a seal member including the translucent material may be provided to the package 3 for the purpose of protection of the LED chip 1 and the first wavelength conversion part 2.

In addition, the control device of the illumination device 20 according to the present embodiment includes the control device (not shown in the drawing) to which the electric power is supplied by a power source, which is able to separately control the respective optical outputs of two types of the light emitting devices 10b and 10y. Here, the control device, for example, includes: a storage part for storing a table relating the color temperature in adjusting the color temperature of light radiated from the illumination device 20 to the optical outputs of the light emitting devices 10b and 10y of the respective emission colors; the respective lighting circuit part for lighting the light emitting devices 10b and 10y respectively; a current control circuit part for controlling a current value of a driving current supplied to the respective lighting circuit parts, and is configured to control the optical outputs of the light emitting devices 10b and 10y on the basis of a toning signal corresponding to the color temperature set by an operation of a color temperature set part (not shown in the drawing).

That is, the illumination device 20 preliminarily measures a relationship between the color temperature and the current value of the drive current to the respective light emitting devices 10b and 10y to store the table relating the color temperature to the optical output ratios of the respective light emitting devices 10b and 10y in the storage part of a microcomputer composing the current control circuit part so that the color temperature of the mixed color light radiated from the illumination device 20 can be changed on a line segment connecting the above-mentioned color temperature points Wb and Wy along the black-body locus BL shown in the xy color temperature chart of Fig. 1(c).

Accordingly, when controlling the optical output ratio by changing the current value of the drive current to the respective light emitting devices 10b and 10y on the basis of the color temperature set by the operation of the color temperature set part, the illumination device 20 is able to adjust, on the Planckian locus BL, the color temperature of mixed color light radiated from the illumination device 20.

In addition, in the relationship between the color temperature and the lighting intensity, a sense of luminance generally tends to be felt dark when the color temperature is low, even in the same lighting intensity. Then, when the control device of the illumination device 20 controls the optical output ratios of the respective light emitting devices 10b and 10y so that the lighting intensity can be the higher, the lower the color temperature of the radiated mixed color light becomes, the illumination device 20 is able to vary the color tone of radiated mixed color, giving a substantially-constant sense of luminance to a viewing person.

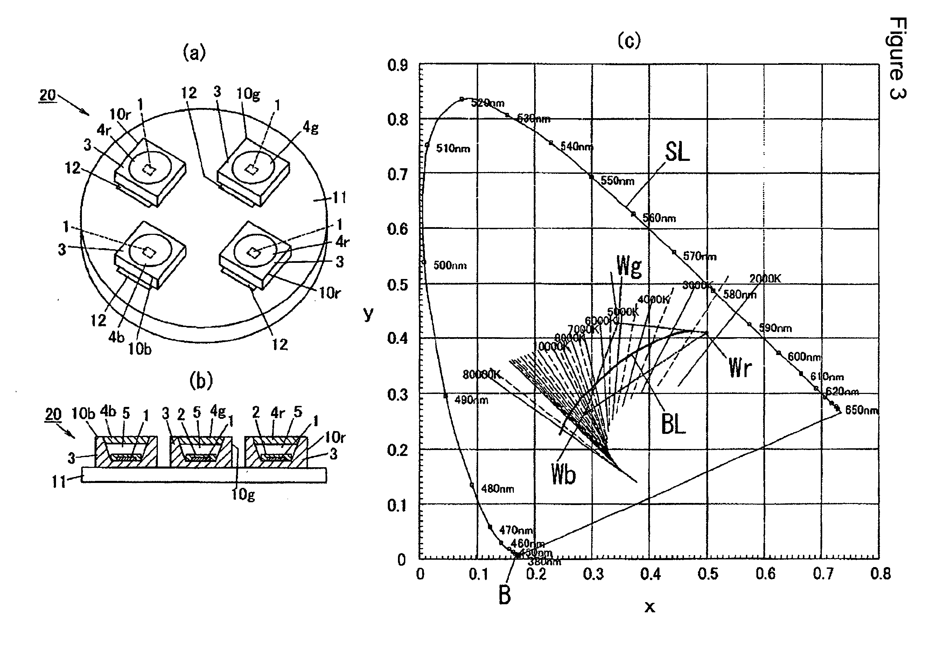

(Second Embodiment)
An illumination device 20 according to the present embodiment shown in Figs. 3(a) and (b) is different in that three types of light emitting devices 10r, 10g, and 10b emitting three color temperatures Wr, Wg, and Wb on the xy color temperature chart shown in Fig. 3 are used instead of using two types of the light emitting devices 10b and 10y in the illumination device 20 according to the first embodiment shown in Fig. 1. Meanwhile, the same numerals are given to the same components as those of the first embodiment, and accordingly their explanations will be arbitrarily omitted.

In an additive color mixture for controlling an optical output ratio of the light radiated from three types of the light emitting devices 10r, 10g, and 10b of different emission colors, the illumination device 20 according to the present embodiment is configured so as to obtain the mixed color light of a desired color tone.

Specifically, the light emitting device 10b of the illumination device 20 according to the present embodiment includes: the LED chip 1 for radiating the blue light; the first wavelength conversion part 2 for absorbing a part of the blue light from the LED chip 1 and converting the wavelength to emit yellow fluorescence; and the second wavelength conversion part 4b, and radiates the bluish white light. The light emitting device 10g includes: the LED chip 1 for radiating the blue light; and the first wavelength conversion part 2 for absorbing a part of the blue light from the LED chip 1 and converting the wavelength to emit yellow fluorescence and the second wavelength conversion part 4g for absorbing a part of the blue light from the blue LED chip 1 and converting the wavelength to emit green fluorescence, and radiates the greenish white light. In addition, the light emitting device 10r includes: the blue LED chip 1 for radiating the blue light; and the first wavelength conversion part 2 for absorbing a part of the blue light from the blue LED chip 1 and converting the wavelength to emit yellow fluorescence and the second wavelength conversion part 4 for absorbing a part of the blue light from the blue LED chip 1 and converting the wavelength to emit red fluorescence, and radiates the orangish white light.

Here, the light emitting devices 10r, 10g, and 10b includes: the blue LED chip 1 for radiating the blue light; and the first wavelength conversion part 2 for absorbing a part of the blue light from the blue LED chip 1 and converting the wavelength to emit the fluorescence, respectively, and obtains the emission light of three colors by combining the second wavelength conversion part 4r, 4g, and 4b in accordance with the different emission color.

That is, the respective light emitting devices 10r, 10g, and 10b are configured by arranging the common LED chip 1 for emitting the blue light on the internal bottom surface of the concave portion in the common package 3 and covering the LED chip 1 with the common first wavelength conversion part 2, as a basic configuration.

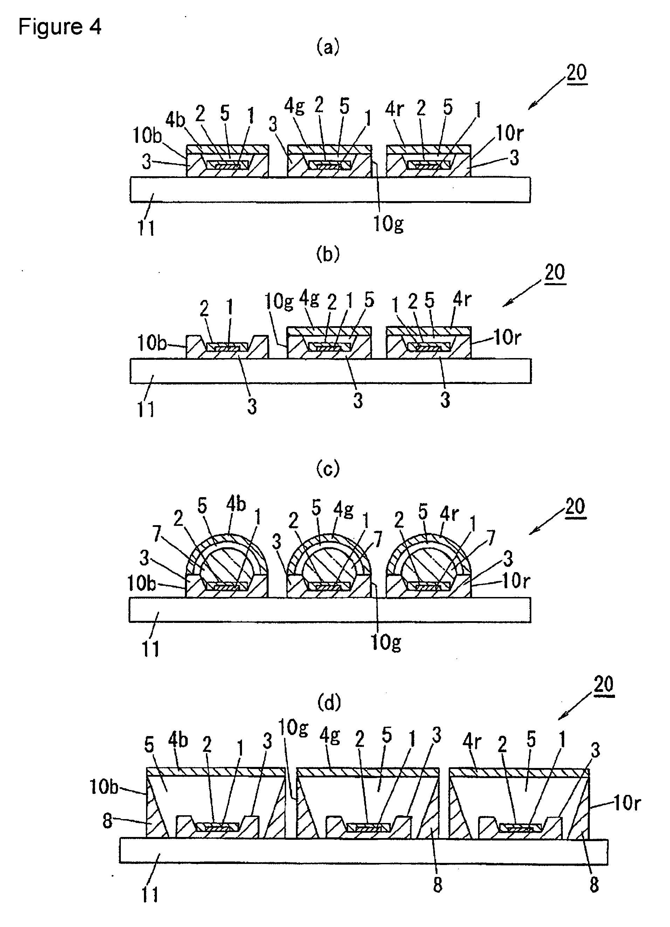

Meanwhile, as the configuration of each light-emitting device 10b, instead of providing the respective second wavelength conversion parts 4r, 4g, and 4b in the concave portions of the packages 3 of the light emitting devices 10r, 10g, and 10b shown in Fig. 3(b) via the first wavelength conversion part 2 and the air layer 5, the respective planer second wavelength conversion parts 4r, 4g, and 4b may be formed on the concave portions in the respective packages 3, and the second wavelength conversion parts 4r, 4g, and 4b and the first wavelength conversion part 2 covering the LED chip 1 may be arranged to face each other via the air layer 5, as in the illumination device 20 shown in Fig. 4(a).

In addition, as in the illumination device 20 shown in Fig. 4(b), only the light emitting device 10b for emitting the bluish white light of the light emitting devices 10r, 10g, and 10b may be formed by the package 3 using the LED chip 1 and the first wavelength conversion part 2 without using the second wavelength conversion part 4b.

Moreover, as shown in Fig. 4(c), the respective light emitting devices 10b, 10g, and 10r of the illumination device 20 may seal the LED chip 1 and the first wavelength conversion part 2 inside the second wavelength conversion parts 4r, 4g, and 4b, may include a sealing part 7 including a domed translucent material (for example, a silicone resin) arranged in a surrounding shape in a intermediate portion with the package 3, and may form the air layer 5 between the inside surfaces of the second wavelength conversion parts 4r, 4g, and 4b and the light emitting surfaces of the respective sealing parts 7. The above-mentioned light emitting devices 10b, 10g, and 10r are able to suppress the propagation of the light from the respective second wavelength conversion parts 4r, 4g, and 4b to the respective sealing parts 7 and to improve the efficiency of the light extraction to the outside.

Furthermore, as shown in Fig. 4(d), the light emitting devices 10r, 10g, and 10b of the illumination device 20 may be configured by using, as a basic configuration, the package 3 of the same configuration where the LED chip 1 and the first wavelength conversion part 2 covering the LED chip 1 are arranged and by arranging the package 3 inside a storage part 8 in which the second wavelength conversion parts 4r, 4g, and 4b each emitting a different color are separately provided on a light emitting surface side.

In this manner, each of the light emitting devices 10r, 10g, and 10b of the illumination device 20 according to the present embodiment uses the LED chip 1 on the internal bottom surface of the package 3 and the first wavelength conversion part 2 covering the LED chip 1 as the basic configuration of the same specification, provides the second wavelength conversion parts 4r, 4g, and 4b each emitting a different color respectively, and accordingly the heat is generated mainly in the package 3 of the same specification having the LED chip 1 and the first wavelength conversion part 2.

Since the heat is commonly generated in the light emitting devices 10r, 10g, and 10b of any emission colors, the color deviation due to the usage environment and temporal change of the mixed color light radiated from the illumination device 20 can be suppressed and the mixed color light of a desired color tone can be stably obtained.

Meanwhile, the light emitting devices 10r, 10g, and 10b of the illumination device 20 are also able to suppress the color deviation due to the heat generation of the LED chip 1 more in the second wavelength conversion parts 4r, 4g, and 4b and to improve the reliability, for example, by arranging: the second wavelength conversion parts 4r, 4g, and 4b; and the LED chip 1 and the first wavelength conversion part 2 covering the LED chip 1 on the internal bottom surface of the concave portion in the package 3 to face each other via the air layer 5, and by being configured to be thermally separated.

Moreover, in the illumination device 20 according to the present embodiment, the light radiated from the light emitting devices 10r, 10g, and 10b of different emission colors are set to a color temperature points Wr, Wg, and Wb in the xy color temperature chart of Fig. 3(c), respectively, and the mixed color light within a range illustrated in a triangle shown by a dashed line can be radiated from the illumination device 20; however, the color temperature points of the light radiated from the respective light emitting devices 10r, 10g, 10b, and the like configuring the illumination device 20 on the xy color temperature chart is not limited to the triangle, for example, may be a polygonal shape such as a pentagon using five types of the light emitting devices of different emission colors.

Furthermore, the illumination device 20 according to the present embodiment may arrange a diffusion panel formed of a diffusion translucent material so that the diffusion panel can face the circuit substrate 11, and may improve the characteristic of color mixing of the light radiated from the respective light emitting devices 10b, 10g, and 10r.

In addition, instead of mounting the respective light emitting devices 10b, 10g, and 10r on the circuit substrate 11, the light emitting devices 20, for example, may be mounted on a base member such as a fixture body formed of a material with a high thermal conductivity (the metal and the like) in the illumination device 20, and the circuit substrate 11 forming a plurality of window holes for exposing a part of or all of the respective light emitting devices 10b, 10g, and 10r may be arranged to face the base member.

### (Third Embodiment)

The present embodiment is different in that the light emitting device 10b having the diffusion layer 9 for diffusing the light radiated from the first wavelength conversion part 2 and the LED chip 1 shown in Fig. 5 is used instead of using the light emitting device 10b that does not have the second wavelength conversion part 4b in the illumination device 20 shown in Fig. 4(b) according to the second embodiment. Meanwhile, the same numerals are given to the same components as those of the second embodiment, and accordingly their explanations will be arbitrarily omitted.

In the illumination device 20 of Fig. 4(b), only the light emitting device 10b of the light emitting devices 10r, 10g, and 10b is not provided with the second wavelength conversion part. For this reason, a light distribution characteristic of the light radiated from the respective light emitting devices 10r, 10g, and 10b of the illumination device 20 is different in the light transmitting the second wavelength conversion parts 4r and 4g and in the light radiated from the first wavelength conversion part 2 without the second wavelength conversion part.

More specifically, the light emitting devices 10r, 10g, 10b of the illumination device 20 shown in Fig. 5(a) according to the present embodiment include the fluorescence as the second wavelength conversion parts 4r and 4g provided on the package 3. Accordingly, the light radiated from the respective light emitting devices 10r, 10g, 10b are scattered by the fluorescence of the second wavelength conversion parts 4r and 4g to be in a different light distribution characteristic.

As the result, in a case where the light distribution is controlled by a light distribution control part (not shown in the drawing) configured by an optical system such as a lens and a reflecting mirror, the mixed color light radiated from the illumination device 20 tends to emphasize the difference caused by the light distribution characteristic of the light radiated to a light distribution pattern on an irradiated surface of the illumination device 20 from the respective light emitting devices 10r, 10g, and 10b, and accordingly a color unevenness may outstand.

That is, in the light emitting devices 10r, 10g, and 10b of the illumination device 20, the extent of diffusion of the light is different in the light emitting devices 10r and 10g using the second wavelength conversion parts 4r and 4g and in the light emitting device 10b not using the second wavelength conversion part, and the extent of diffusion of the light radiated from the light emitting device 10b not using the second wavelength conversion part is lowered. Consequently, in the illumination device 20 shown in Fig. 5(a) according to the present embodiment, the diffusion layer 9 including a light diffusion material is arranged in the light emitting device 10b not using the second wavelength conversion part instead of the second wavelength conversion parts 4r and 4g in the other light emitting devices 10r and 10g. The diffusion layer 9 evens the extent of diffusion of the light radiated from the respective light emitting devices 10r, 10g, and 10b by adjusting a content ratio to the translucent material (for example, the silicone resin and the like) including the light diffusion material, is able to uniform the light distribution characteristic of the mixed color light radiated from the illumination device 20, and accordingly is able to improve the characteristic of the color mixing of the light radiated from the illumination device 20.

Next, as another illumination device 20 according to the present embodiment, another illumination device 20 shown in Fig. 5(b) according to the present embodiment blends the light distribution member in a second wavelength conversion part 4g' in addition to the configuration of the illumination device 20 of Fig. 5(a) so as to substantially uniform the light distribution characteristic of the light radiated from the second wavelength conversion parts 4r and 4g' of the light emitting devices 10r and 10g.

More specifically, the light emitting devices 10r, 10g, and 10b of the illumination device 20 according to the present embodiment shown in Fig. 5(b) sometimes use two types of the wavelength conversion parts 4r and 4g' each having different concentration of the contained fluorescence in the respective colors as the second wavelength conversion parts 4r and 4g' provided on the package 3. Accordingly, the light emitting devices 10r, 10g, and 10b of the illumination device 20 are different in the extent of the light scattered by the fluorescence of the second wavelength conversion parts 4r and 4g'.

However, the illumination device 20 shown in Fig. 5(b) according to the present embodiment uniforms the light distribution characteristic of the light radiated from the light emitting devices 10r and 10g due to the blending of the light distribution material in the second wavelength conversion part 4g' by including the light diffusion material in the second wavelength conversion part 4g' of the light emitting device 10g.

Meanwhile, the larger a difference of the reflective index to the translucent material (for example, the silicone) serving as a binder for including the fluorescence of the second wavelength conversion part 4g' becomes, the more the light diffusion material (not shown in the drawing) included in the second wavelength conversion part 4g' is able to enlarge the extent of scattering of the light. Accordingly, when the light distribution characteristic of the light radiated from the second wavelength conversion part 4g' is substantially in the same extent of diffusion of the light, the more the light diffusion material that is a material having the larger difference of the reflective index between the light diffusion material and the translucent material is used, the more a content ratio of the light diffusion material in the translucent material can be reduced.

As such material of the light diffusion material, an inorganic material such as aluminum oxide, silica, and titanium oxide, organic material such as a fluorinated resin, particles such as an organic-inorganic hybrid material made by combining an organic constituent and an inorganic constituent in a molecular level or in a particle level, a hole formed in the translucent material are shown for example, and the mean particle diameter may be arbitrarily selected, for example, from a few micrometers to tens of micrometers.

In addition, in the illumination device 20 shown in Fig. 5(b), the light diffusion material was included only in the second wavelength conversion part 4g' of the light emitting device 10g; however, the light diffusion material may be included only in the second wavelength conversion part 4r of the light emitting device 10r, and the light diffusion material may be included in the light emitting devices 10r and 10g, respectively.

### (Fourth Embodiment)

In the present embodiment, instead of using the second wavelength conversion parts 4r, 4g, and 4b each including the different fluorescence of the light emitting devices 10r, 10g, and 10b in the illumination device 20 shown in Fig. 3 according to the second embodiment, the second wavelength conversion parts 4r, 4g, and 4b are different in that the second wavelength conversion parts 4r, 4g, and 4b include two or more types of common fluorescent substances and the content ratios of the fluorescence are different.

In order to radiate the light of different emission colors, the light emitting devices 10r, 10g, and 10b configuring the illumination device 20 according to the present embodiment use the LED chip 1, the first wavelength conversion part 2, and the package 3 that have the same specification. Additionally, there are three types of the second wavelength conversion parts 4r, 4g, and 4b of the light emitting devices 10r, 10g, and 10b in the respective light emitting devices 10r, 10g, and 10b, the respective second wavelength conversion parts 4r, 4g, and 4b include two or more types of the common fluorescent substances (for example, the green fluorescent substance absorbing blue light to emit green fluorescence, and the red fluorescent substance absorbing blue light to emit red fluorescence) in the translucent material serving as the binder, and the color tones of light radiated from the second wavelength conversion parts 4r, 4g, and 4b are controlled by changing the content ratios of the respective fluorescent substances so as to be, for example, the content ratio shown in the table 1 described below

**[Table 1]**

| | Green fluorescent substance: Red fluorescent substance | Content concentration of fluorescent substance in translucent material |
|---|---|---|
| Light emitting device 10b | 80.4:19.6 | 1.5% |
| Light emitting device 10g | 97.7:2.3 | 4.5% |
| Light emitting device 10r | 68.1:31.9 | 5.2% |

As the result, all light emitting devices 10r, 10g, and 10b of the illumination device 20 are able to easily design the color temperatures of light of different emission colors radiated from the light emitting devices 10r, 10g, and 10b only by adjusting the content ratios of the respective fluorescent substances. Additionally, in the illumination device 20, since the second wavelength conversion parts 4r, 4g, and 4b in the light emitting devices 10r, 10g, and 10b are combined by the common same fluorescent substance, the initial characteristic and the temporal change characteristic of the LED chip 1 and the second wavelength conversion parts 4r, 4g, and 4b are substantially the same, and accordingly the color deviation due to a surrounding environment, the passage of time can be suppressed.

### [Description of Reference Numerals]

1 LED chip (light emitting element)
2 First wavelength conversion part
3 Package
4r, 4g, 4b, 4b', and 4y Second wavelength conversion part 9 Diffusion layer
10r, 10g, 10b, and 10y Light emitting device
20 Illumination device

## Claims

1. An illumination device (20) comprising: a plurality of light emitting devices (10r, 10g, 10b, 10y) of different emission colors; and a control device for controlling an optical output ratio in the plurality of the light emitting devices, able to change a color tone in mixed color light of light radiated from the plurality of the light emitting devices (10r, 10g, 10b, 10y) of different emission colors, wherein
each of the plurality of the light emitting device (10r, 10g, 10b, 10y) includes: a light emitting element (1); and a first wavelength conversion part (2) for absorbing at least a part of light radiated from the light emitting element (1) and converting the wavelength to emit fluorescence, and
' a part of the light emitting devices (10r, 10g, 10b, 10y) among the plurality of the light emitting devices (10r, 10g, 10b, 10y) include a second wavelength conversion part (4r, 4g, 4b, 4y) for converting wavelengths of at least a part of the light radiated from at least one of the light emitting element (1) and the first wavelength conversion part (2) into an emission color different from the emission color of the light radiated from the light emitting element (1) and the first wavelength conversion part (2), **characterized in that**
the second wavelength conversion part (4r, 4g, 4b, 4y) is separated from the first wavelength conversion part (2) via an air layer (5).

2. The illumination device according to claim 1, wherein
the second wavelength conversion part (4r, 4g, 4b, 4y) includes a light diffusion material for diffusing light.

3. The illumination device according to claim 1 or claim 2, wherein
the light emitting device (10b) not having the second wavelength conversion part (2) among the plurality of the light emitting devices (10r, 10g, 10b, 10y) includes a diffusion layer for diffusing light from the first wavelength conversion part.

4. The illumination device according to one of claims 1 to 3, wherein
plural types of the second wavelength conversion parts (4r, 4g, 4b, 4y) are used in each the light emitting device,
the respective second wavelength conversion parts (4r, 4g, 4b) include two or more types of common fluorescent substances, and
content ratios of two or more types of the fluorescent substances are different.

5. The illumination device according to claim 1, wherein
the second wavelength conversion part (4y) is separately provided on a light emitting surface side via the air layer (5), and the second wavelength conversion part (4y) includes a yellow fluorescent substance excited by at least one of the blue light radiated from the light emitting element (1) and the first wavelength conversion part (2) each emitting blue-violet light.

6. The illumination device according to claim 1, wherein
the planar second wavelength conversion part (4r, 4g, 4b) may be formed on a concave portions in a respective package (3), and the second wavelength conversion part (4r, 4g, 4b) and the first wavelength conversion part (2) covering the ligt emitting element (1) may be arranged to face each other via the air layer (5).

7. The illumination device according to claim 1, wherein
the light emitting element (1) and the first wavelength conversion part (2) is sealed inside the second wavelength conversion part (4r, 4g, 4b), the illumination device includes a sealing part (7) including a domed translucent material arranged in a surrounding shape in a intermediate portion of a package (3), and forms the air layer (5) between the inside surfaces of the second wavelength conversion part (4r, 4g, 4b) and the light emitting surface of the sealing part (7).

8. The illumination device according to claim 1, wherein
the light emitting element (1) and the first wavelength conversion part (2) covering the light emitting element (1) on the internal bottom surface of a concave portion in a package (3) face the second wavelength conversion part (4r, 4g, 4b) via the air layer (5) so as to be thermally separated.

## Patentansprüche

1. Beleuchtungsvorrichtung (20) aufweisend: eine Mehrzahl von lichtemittierenden Einrichtungen (10r, 10g, 10b, 10y) mit verschiedenen Emissionsfarben; und eine Steuereinrichtung zur Steuerung der optischen Emissionsanteile bei der Mehrzahl der lichtemittierenden Einrichtungen, die in der Lage ist, einen Farbton in dem gemischten farbigen Licht des von der Mehrzahl von lichtemittierenden Einrichtungen (10r, 10g, lOb, 10y) der verschiedenen Emissionsfarben abgestrahlten Licht zu ändern, wobei
jede der Mehrzahl von lichtemittierenden Einrichtungen (10r, 10g, 10b, 10y) aufweist: ein lichtemittierendes Element (1); und ein erstes Wellenlängenkonvertierungsteil (2) zum Absorbieren zumindest eines Teils des von dem lichtemittierenden Element (1) abgestrahlten Lichts und zum Konvertieren der Wellenlänge zur Fluoreszenzemission, und
ein Teil der lichtemittierenden Einrichtungen (10r, 10g, 10b, 10y) unter der Mehrzahl der lichtemittierenden Einrichtungen (10r, 10g, 10b, 10y) ein zweites Wellenlängenkonvertierungsteil (4r, 4g, 4b, 4y) aufweist, um die Wellenlängen von zumindest einem Teil des von dem lichtemittierenden Element (1) und/oder dem ersten Wellenlängenkonvertierungsteil (2) abgestrahlten Lichts in eine Emissionsfarbe zu konvertieren, die verschieden von der Emissionsfarbe des Lichts ist, das von dem lichtemittierenden Element (1) und dem ersten Wellenlängenkonvertierungsteil (2) abgestrahlt wird, **dadurch gekennzeichnet,**
**dass** das zweite Wellenlängenkonvertierungsteil (4r, 4g, 4b, 4y) von dem ersten Wellenlängenkonvertierungsteil (2) durch eine Luftschicht (5) getrennt ist.

2. Beleuchtungsvorrichtung nach Anspruch 1, wobei das zweite Wellenlängenkonvertierungsteil (4r, 4g, 4b, 4y) ein Lichtdiffusionsmaterial zur Lichtdiffusion enthält.

3. Beleuchtungsvorrichtung nach Anspruch 1 oder 2, wobei die lichtemittierende Einrichtung (10b), die unter der Mehrzahl von lichtemittierenden Einrichtungen (10r, 10g, 10b, 10y) kein zweites Wellenlängenkonvertierungsteil (2) hat, eine Diffusionsschicht zur Lichtdiffusion des Lichts von dem ersten Wellenlängenkonvertierungsteil aufweist.

4. Beleuchtungsvorrichtung nach einem der Ansprüche 1 bis 3, wobei mehrere Typen des zweiten Wellenlängenkonvertierungsteils (4r, 4g, 4b, 4y) in jeder lichtemittierenden Einrichtung verwendet werden,
wobei das betreffende zweite Wellenlängenkonvertierungsteil (4r, 4g, 4b) zwei oder mehr Typen üblicher fluoreszierender Substanzen aufweist und
wobei die Anteile der zwei oder mehr Typen der fluoreszierenden Substanzen unterschiedlich sind.

5. Beleuchtungsvorrichtung nach Anspruch 1, wobei das zweite Wellenlängenkonvertierungsteil (4y) separat an einer lichtemittierenden Seitenfläche über eine Luftschicht (5) angeordnet ist und das zweite Wellenlangenkonvertierungsteil (4y) eine gelb fluoreszierende Substanz enthält, das blaue Licht angeregt wird, das von dem lichtemittierenden Element (1) und/oder dem ersten Wellenlängenkonvertierungsteil (2) abgestrahlt wird, die jeweils blauviolettes Licht emittieren.

6. Beleuchtungsvorrichtung nach Anspruch 1, wobei das ebene zweite Wellenkonvertierungsteil (4r, 4g, 4b) auf einem konkaven Abschnitt in einer jeweiligen Anordnung (3) ausgebildet sein kann und wobei das zweite Wellenlängenkonvertierungsteil (4r, 4g, 4b) und das erste Wellenlängenkonvertierungsteil (2), das das lichtemittierende Element (1) abdeckt, einander über die Luftschicht (5) zugewandt angeordnet sein können.

7. Beleuchtungsverrichtung nach Anspruch 1, wobei das lichtemittierende Element (1) und das erste Wellenlangenkonvertierungsteil (2) in dem zweiten Wellenlängenkonvertierungsteil (4r, 4g, 4b) abgedichtet sind, wobei die Beleuchtungsvorrichtung ein Dichtungsteil (7) enthält, das ein gewölbtes lichtdurchlässiges Material aufweist, das in einer umschließenden Gestalt in einem Zwischenbereich der Anordnung (3) angeordnet ist und die Luftschicht (5) zwischen den Innenflächen des zweiten Wellenlängenkonvertierungsteils (4r, 4g, 4b) und der Lichtaustrittsfläche des Dichtungsteils (7) gebildet ist.

8. Beleuchtungsvorrichtung nach Anspruch 1, wobei das lichtemittierende Element (1) und das erste Wellenlangenkonvertierungsteil (2), das das lichtemittierende Element (1) auf der inneren Bodenfläche eines konkaven Abschnitts in der Anordnung (3) abdeckt, dem zweiten Wellenlängenkonvertierungsteil (4r, 4g, 4b) über die Luftschicht (5) zugewandt ist, um thermisch getrennt zu sein.

## Revendications

1. Dispositif (20) d'éclairage comprenant : une pluralité de dispositifs électroluminescents (1 dur, 10g, 10b, 10y) de couleurs différentes d'émission et un dispositif de commande, destiné à commander un rendement optique dans la pluralité des dispositifs électroluminescents, apte à faire passer un ton dans une lumière colorée mixte de lumière rayonnée par la pluralité des dispositifs électroluminescents 10r, 10g, 10b, 10y) de couleurs différentes d'émission, dans lequel
chaque élément de à pluralité des dispositifs électroluminescents (10r, 10g, 10b, 10y) comporte : un élément électroluminescent (1) et une première partie (2) de conversion de longueur d'onde, destinée à absorber au moins une partie de la lumière rayonnée par l'élément électroluminescent (1) et à convertir la longueur d'onde pour émettre de la fluorescence et
une partie des dispositifs électroluminescents (10r, 10g, 10b, 10y) parmi la pluralité des dispositifs électroluminescents (10r, 10g, 10b, 10y) comporte une seconde partie (4r, 4g, 4b, 4y) de conversion de longueur d'onde, destinée à convertir les longueurs d'ondes d'au moins une partie de la lumière rayonnée par au moins un élément parmi l'élément électroluminescent (1) et la première partie (2) de conversion de longueur d'onde en une couleur d'émission différente de la couleur d'émission de la lumière rayonnée par l'élément électroluminescent (1) et la première partie (2) de conversion de longueur d'onde,
**caractérisé en ce que**
la seconde partie (4r, 4g, 4b, 4y) de conversion de longueur d'onde est séparée de la première partie (2) de conversion de longueur d'onde par l'intermédiaire d'une couche d'air (5).

2. Dispositif d'éclairage selon la revendication 1, dans lequel
la seconde partie (4r, 4g, 4b, 4y) de conversion de longueur d'onde comporte un matériau de diffusion de la lumière, destiné à diffuser de la lumière.

3. Dispositif d'éclairage selon la revendication 1 ou la revendication 2, dans lequel
le dispositif électroluminescent (10b), n'ayant pas la seconde partie (2) de conversion de longueur d'onde parmi la pluralité des dispositifs électroluminescents (10r, 1 du, 10b, 1 dry), comporte une couche de diffusion, destinée à diffuser de la lumière par la première partie de conversion de longueur d'onde.

4. Dispositif d'éclairage selon l'une des revendications 1 à 3, danslequel
plusieurs types des secondes parties (4r, 4g, 4b, 4y) de conversion de longueur d'onde sont utilisés dans chaque dispositif électroluminescent,
les secondes parties (4r, 4g, 4b) respectives de conversion de longueur d'onde comportent deux types ou plus de substances fluorescentes communes et
les rapports de contenu de deux types ou plus des substances fluorescentes sont différents.

5. Dispositif d'éclairage selon la revendication "I, dans lequel
la seconde partie (4y) de conversion de longueur d'onde est prévue séparément sur un côté de la surface électroluminescente par l'intermédiaire de la couche (5) d'air et la seconde partie (4y) de conversion de longueur d'onde comporte une substance fluorescente jaune, excitée par au moins un élément parmi la lumière bleue rayonnée par l'élément électroluminescent (1) et la première partie (2) de conversion de longueur d'onde, chacun émettant une lumière bleu violet.

6. Dispositif d'éclairage selon la revendication 1, dans lequel
la seconde partie plantaire (4r, 4g, 4b) de conversion de longueur d'onde peut être formée sur une partie concave dans un boîtier (3) respectif et la seconde partie (4r, 4g, 4b) de conversion de longueur d'onde et la première partie (2) de conversion de longueur d'onde, couvrant l'élément électroluminescent (1), peuvent être agencées pour se faire face mutuellement par l'intermédiaire de la couche (5) d'air.

7. Dispositif d'éclairage selon la revendication 1, dans lequel l'élément électroluminescent (1) et la première partie (2) de conversion de longueur d'onde sont rendues étanches à l'intérieur de la seconde partie (4r, 4g, 4b) de conversion de longueur d'onde, le dispositif d'éclairage comporte une partie (7) d'étanchéité, comportant un matériau translucide bombé, agencé en une forme environnante dans une partie intermédiaire d'un boîtier (3) et forme la couche (5) d'air entre les surfaces intérieures de la seconde partie (4r, 4g, 4b) de conversion de longueur d'onde et la surface électroluminescente de la partie (7) d'étanahéifië.

8. Dispositif d'éclairage selon la revendication 1, dans lequel l'élément électroluminescent (1) et la première partie (2) de conversion de longueur d'onde, couvrant l'élément électroluminescent (1) sur la surface inférieure interne d'une partie concave dans un boîtier (3), font face à la seconde partie (4r, 4g, 4b) de conversion de longueur d'onde par l'intermédiaire de la couche (5) d'air, de maçon à être séparés thermiquement.
